# EUROPÄISCHE PATENTSCHRIFT

(11) **EP 3 422 027 B1**
(45) Veröffentlichungstag und Bekanntmachung des Hinweises auf die Patenterteilung: **25.03.2020**
(21) Anmeldenummer: 18178224.4
(22) Anmeldetag: 18.06.2018
(51) Int. Cl.: G01R 31/02

(54) **VORRICHTUNG, VERFAHREN, HERSTELLVERFAHREN FÜR DAS TESTEN VON KABELBÄUMEN**
DEVICE, METHOD, PRODUCTION METHOD FOR TESTING CABLE HARNESSES
DISPOSITIF, PROCÉDÉ, PROCÉDÉ DE FABRICATION POUR TESTER FAISCEAUX DE CÂBLES

(30) Priorität: 19.06.2017 DE 102017113413
(43) Veröffentlichungstag der Anmeldung: 02.01.2019
(73) Patentinhaber: Lisa Dräxlmaier GmbH, 84137 Vilsbiburg (DE)
(72) Erfinder: Ehrhardt, Othmar, 84326 Rimbach (DE); Giftthaler, Konrad, 84036 Hohenegglkofen (DE)

(56) Entgegenhaltungen:
- EP-A2- 1 014 099
- DE-A1-102011 087 152
- US-A- 3 252 087
- US-A1- 2005 083 067
- US-A1- 2008 224 712

## Beschreibung

### Technisches Gebiet

Die vorliegende Erfindung betrifft eine Vorrichtung zum Prüfen eines Kabelbaums. Ferner betrifft die vorliegende Erfindung ein entsprechendes Verfahren und ein entsprechendes Herstellverfahren für einen Kabelbaum.

### Stand der Technik

Die vorliegende Erfindung wird im Folgenden hauptsächlich in Verbindung mit Kabelbäumen für Fahrzeuge beschrieben. Es versteht sich, dass die vorliegende Erfindung aber nicht auf solche Kabelbäume für Fahrzeuge beschränkt ist, sondern auf alle Arten von Verkabelungen in elektrischen Systemen und Anlagen angewandt werden kann.

In modernen Fahrzeugen wird üblicherweise eine Vielzahl von elektrischen Komponenten eingesetzt. Solche elektrischen Komponenten können beispielsweise passive Komponenten, wie die Fahrzeugbeleuchtung, oder aktive Komponenten, wie Fahrerassistenzsysteme, aufweisen. Die einzelnen Komponenten werden üblicherweise in dem Fahrzeug verteilt angeordnet und durch elektrische Leitungen miteinander gekoppelt. Da die Anzahl von Steuergeräten und weiteren elektrischen Komponenten in modernen Fahrzeugen immer größer wird, werden auch die Verkabelungen immer komplexer.

Um die Verkabelung eines modernen Fahrzeugs handhaben zu können, werden üblicherweise vorgefertigte Kabelbäume eingesetzt, die vorgefertigt werden können. Solche Kabelbäume weisen für jedes anzuschließende Gerät einen entsprechenden Stecker auf und verbinden das Gerät mit den jeweiligen Gegenstellen. Kabelbäume für moderne Fahrzeuge können hunderte von Steckern oder Buchsen aufweisen, welche wiederum jeweils mehrere elektrische Kontakte beherbergen können.

Bei der Herstellung solcher Kabelbäume muss daher sichergestellt werden, dass die einzelnen Kontakte korrekt verkabelt sind, in dem Kabelbaum die einzelnen elektrischen Netzwerke also korrekt ausgebildet sind.

Beispielsweise können die einzelnen elektrischen Netzwerke mit einer Gleichspannung beaufschlagt werden und an allen Anschlüssen des jeweiligen elektrischen Netzwerks gemessen werden, ob die Gleichspannung an allen Kontakten des jeweiligen elektrischen Netzwerks anliegt.

Eine solche Überprüfung, also beispielsweise Vermessung, der einzelnen Netzwerke ist allerdings sehr aufwändig und fehleranfällig. Ferner kann immer nur eines der Netzwerke geprüft werden, da sich überlagernde elektrische Netzwerke nicht erkannt werden können, wenn gleichzeitig zwei elektrische Netzwerke mit der Spannung beaufschlagt werden.

Die US 2005 / 083 067 A1 zeigt ein Testsystem für ein einzelnes mehradriges Kabel. Die US 4 257 002 A zeigt ein Testsystem für Kabelsätze. Die US 2008 / 0 224 712 A1 zeigt ein kontaktloses Testsystem für Kabelsätze. Weitere Testsysteme sind in US 3 252 087, in EP 1 014 099 und in DE 10 2011 087152 beschrieben.

### Beschreibung der Erfindung

Eine Aufgabe der Erfindung ist es daher, unter Einsatz konstruktiv möglichst einfacher Mittel eine einfache Überprüfung von Kabelbäumen zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Eine erfindungsgemäße Vorrichtung kann zum Prüfen eines Kabelbaums mit einer Vielzahl von Netzwerken, welche durch Verbindungselemente, beispielsweise Stecker und Buchsen, mit einzelnen Kontakten, die durch Leitungen miteinander gekoppelt sind, gebildet werden, dienen. Die Vorrichtung weist einen Signalgenerator auf, welcher ausgebildet ist, mindestens ein Testsignal mit einer vorgegebenen Frequenz zu erzeugen. Ferner weist die Vorrichtung eine Koppelvorrichtung auf, welche ausgebildet ist, mindestens eines der Netzwerke über einen der Kontakte des Netzwerks zu kontaktieren und das Testsignal in das entsprechende Netzwerk einzuspeisen. Schließlich weist die Vorrichtung eine Prüfeinheit auf, welche ausgebildet ist, die weiteren Kontakte des mindestens einen Netzwerks zu kontaktieren und zu prüfen, ob das Testsignal mit der jeweiligen Frequenz an den weiteren Kontakten anliegt, wobei der Signalgenerator ausgebildet ist, für jedes der Netzwerke ein Testsignal mit einer vorgegebenen Frequenz zu erzeugen, wobei die Koppelvorrichtung ausgebildet ist, jedes der Netzwerke zu kontaktieren und das entsprechende Testsignal in jedes der Netzwerke einzuspeisen, und wobei die Prüfeinheit ausgebildet ist, an den nicht durch die Koppelvorrichtung kontaktierten Kontakten, die Frequenzen zu ermitteln, welche in den Signalen enthalten sind, welche an den Kontakten jeweils anliegen, wobei die Prüfeinheit ausgebildet ist, zu prüfen, ob an den nicht durch die Koppelvorrichtung kontaktierten Kontakten Frequenzen anliegen, welche nicht in das Netzwerk des jeweiligen Kontakts eingespeist werden, wobei die Prüfeinheit ausgebildet ist, für die Kontakte an welchen Frequenzen anliegen, welche nicht in das Netzwerk des jeweiligen Kontakts eingespeist werden, einen Koppelfaktor zu den entsprechenden weiteren Netzwerken zu bestimmen.

Ein Verfahren zum Prüfen eines Kabelbaums mit einer Vielzahl von Netzwerken, welche durch Verbindungselemente mit einzelnen Kontakten, die durch Leitungen miteinander gekoppelt sind, gebildet werden, weist die folgenden Schritte auf: Einspeisen eines Testsignals einer vorgegebenen Frequenz in mindestens eines der Netzwerke über einen der Kontakte des Netzwerks, und Prüfen der weiteren Kontakte, welche dem mindestens einen Netzwerk zugeordnet sind, auf das Vorhandensein des Testsignals, Erzeugen eines Testsignals mit einer vorgegebenen Frequenz für jedes der Netzwerke, wobei beim Einspeisen jedes der Netzwerke kontaktiert wird und das entsprechende Testsignal in jedes der Netzwerke eingespeist wird, und wobei beim Prüfen, an den nicht für die Einspeisung genutzten Kontakten, die Frequenzen ermittelt werden, welche in den Signalen enthalten sind, welche an den Kontakten jeweils anliegen, wobei beim Prüfen geprüft wird, ob an den nicht kontaktierten Kontakten Frequenzen anliegen, welche nicht in das Netzwerk des jeweiligen Kontakts eingespeist werden, und wobei beim Prüfen für die Kontakte an welchen Frequenzen anliegen, welche nicht in das Netzwerk des jeweiligen Kontakts eingespeist werden, einen Koppelfaktor zu den entsprechenden weiteren Netzwerken bestimmt wird.

Ein Herstellverfahren für einen Kabelbaum mit einer Vielzahl von Netzwerken, welche durch Verbindungselemente mit einzelnen Kontakten, die durch Leitungen miteinander gekoppelt sind, gebildet werden, weist die folgenden Schritte auf: Verbinden einzelner Kontakte der Verbindungselemente mit Hilfe von Leitungen, um die Netzwerke in dem Kabelbaum auszubilden, und Prüfen des Kabelbaums gemäß dem erfindungsgemäßen Verfahren zum Prüfen eines Kabelbaums.

Die vorliegende Erfindung wird im Folgenden hauptsächlich in Bezug auf elektrische Netzwerke erläutert und basiert auf der Erkenntnis, dass sich überlagernde Gleichspannungen bei der Prüfung eines Kabelbaums nur mit hohem Aufwand erkannt beziehungsweise auseinandergehalten werden können. Ferner nutzt die vorliegende Erfindung die Erkenntnis, dass Signale, insbesondere elektrische Spannungssignale, mit unterschiedlichen Frequenzen sich zwar überlagern, die einzelnen Frequenzen aber leicht bestimmt werden können.

Die vorliegende Erfindung sieht daher vor, dass zum Prüfen von Kabelbäumen in die einzelnen Netzwerke eines Kabelbaums eben keine Gleichspannung sondern beispielsweise eine Wechselspannung mit einer vorgegebenen Frequenz eingespeist wird. Die Frequenz des Testsignals ist insbesondere für jedes der Netzwerke eine andere. Jedes der Netzwerke wird also mit einem Signal mit einer individuellen Frequenz beaufschlagt.

Wie oben bereits angedeutet, können sich überlagernde Signale unterschiedlicher Frequenz einfach getrennt werden. Es ist also einfach möglich, an allen Anschlüssen eines Netzwerks festzustellen, ob das Testsignal mit der entsprechenden Frequenz vorhanden ist. Werden gleichzeitig mehrere der Netzwerke mit jeweils einem Testsignal beaufschlagt, können gleichzeitig alle Anschlüsse der jeweiligen Netzwerke auf das Vorhandensein des Testsignals mit der entsprechenden Frequenz untersucht werden. Dabei wird jedes der Netzwerke mit einem Testsignal beaufschlagt, dessen Frequenz jeweils individuell je Netzwerk ist. Das Beaufschlagen der einzelnen Netzwerke mit unterschiedlichen Frequenzen kann als Ausleuchten der Netzwerke in unterschiedlichen Farben betrachtet werden, wobei an den entsprechenden Ausgängen die durchgeleiteten Farben erkannt werden können. Bei der Prüfung optischer Netzwerke kann exakt so verfahren werden und unterschiedliche Farben genutzt werden. Hier kann die Auswertung beispielsweise mit Hilfe von Farbfiltern erfolgen.

Es kann also sehr einfach festgestellt werden, ob alle Kontakte der Netzwerke tatsächlich mit dem jeweiligen Netzwerk verbunden sind. Ferner kann auch festgestellt werden, ob Frequenzanteile aus einem anderen Netzwerk an einem Kontakt empfangen werden, die dort nicht empfangen werden sollten.

Es kann mit Hilfe der vorliegenden Erfindung also sehr schnell, beispielsweise auch gleichzeitig für alle Netzwerke eines Kabelbaums, festgestellt werden, ob diese korrekt und fehlerfrei verbunden sind.

In einer Ausführungsform kann der Signalgenerator ausgebildet sein, für jedes der Netzwerke ein Testsignal mit einer vorgegebenen Frequenz zu erzeugen. So kann für ein erstes Netzwerk ein Testsignal mit einer ersten Frequenz und für ein zweites Netzwerk ein Testsignal mit einer zweiten Frequenz erzeugt werden, wobei sich die erste Frequenz von der zweiten Frequenz unterscheidet. Ferner kann die Koppelvorrichtung ausgebildet sein, jedes der Netzwerke zu kontaktieren und das entsprechende - Netzwerk-individuelle - Testsignal in jedes der Netzwerke einzuspeisen. Schließlich kann die Prüfeinheit ausgebildet sein, an den nicht durch die Koppelvorrichtung kontaktierten Kontakten die Frequenzen zu ermitteln, welche in den Signalen enthalten sind, welche an den Kontakten jeweils anliegen.

Erzeugt der Signalgenerator für jedes der Netzwerke ein Testsignal mit einer für das jeweilige Netzwerk individuellen Frequenz, können alle Netzwerke gleichzeitig mit Testsignalen beaufschlagt werden. Dabei können sich die einzelnen Testsignale nicht gegenseitig auslöschen beziehungsweise derart überlagern, dass sie nicht unterschieden werden können.

Der Signalgenerator kann beispielsweise eine Recheneinrichtung, wie beispielsweise einen Mikrocontroller oder einen DSP oder einen FPGA oder CPLD oder dergleichen aufweisen, der an seinen Ausgängen entsprechende Testsignale bereitstellt. Die Testsignale kann die Recheneinrichtung beispielsweise über D/A-Wandler direkt als sinusförmige Signale ausgeben. Ferner kann die Recheneinrichtung auch digitale Signale ausgeben. Solche Signale können beispielsweise PWM-Signale oder binäre Signale sein, welche durch entsprechende analoge Elemente, wie beispielsweise Filter, zu einem, zumindest annähernd, sinusförmigen Testsignal geformt werden können. Alternativ können auch binäre Rechtecksignale mit unterschiedlichen Frequenzen genutzt werden. Bei der Wahl solcher Rechtecksignale ist bei der Frequenzauswahl zu beachten, dass die Harmonischen der Grundfrequenzen hinzukommen und bei der Auswertung eventuell berücksichtigt werden müssen. Dafür vereinfacht sich die Signalerzeugung für binäre Rechtecksignale deutlich.

Die Koppelvorrichtung ist mit dem Signalgenerator gekoppelt und kann ein oder mehrere Verbindungselemente aufweisen, um den Kabelbaum zu kontaktieren. Üblicherweise wird der Kabelbaum Stecker und/oder Buchsen aufweisen. Solche Stecker und/oder Buchsen können jeweils eine Vielzahl von Kontakten aufweisen. Verfügt ein Kabelbaum über einen Stecker oder eine Buchse, an welche alle Netzwerke des Kabelbaums herangeführt sind, kann die Koppelvorrichtung über diesen einen Stecker beziehungsweise diese eine Buchse alle Testsignale in den Kabelbaum einspeisen. Verfügt der Kabelbaum nicht über einen Stecker oder eine Buchse, an welche alle Netzwerke des Kabelbaums herangeführt sind, kann die Koppelvorrichtung mehrere Stecker und/oder Buchsen aufweisen, um den Kabelbaum an den entsprechenden Stellen zu kontaktieren. Unter Stecker beziehungsweise Buchse ist jede Konstruktion zu verstehen, die es ermöglicht die Kontakte des Kabelbaums zu kontaktieren. Es muss sich dabei beispielsweise nicht zwingend um genormte Stecker beziehungsweise Buchsen handeln, die mit dem Kabelbaum in der jeweiligen Anwendung eingesetzt werden. Die Koppelvorrichtung kann beispielsweise auch speziell für die Prüfung angefertigte Stecker beziehungsweise Buchsen aufweisen, die ein einfaches und schnelles Kontaktieren des Kabelbaums ermöglichen. Beispielsweise können vorgesehene Arretierungen bei der Koppelvorrichtung fehlen.

Es versteht sich, dass die Prüfeinheit ebenfalls solche Stecker beziehungsweise Buchsen aufweisen kann, um die Kontakte des Kabelbaums zu kontaktieren. Wie oben erläutert, kontaktiert die Koppelvorrichtung jeweils genau einen Kontakt eines Netzwerks, um das entsprechende Testsignal einzuspeisen. Im Gegensatz dazu kontaktiert die Prüfeinheit gleichzeitig alle anderen Kontakte. Dies ermöglicht es der Prüfeinheit, an allen verbleibenden Kontakten aller Netzwerke gleichzeitig zu prüfen, ob die durch die Koppelvorrichtung jeweils eingespeisten Signale messbar sind.

Die Prüfeinheit kann beispielsweise an jedem der zu prüfenden Kontakte die anliegenden Signale erfassen und digitalisieren. Die in den Signalen enthaltenen Frequenzen kann die Prüfeinheit beispielsweise durch die Wandlung der Signale aus dem Zeitbereich in den Frequenzbereich bestimmen. Dazu kann beispielsweise eine Fourier-Transformation oder eine Fast-Fourier-Transformation genutzt werden.

Folglich kann mit der erfindungsgemäßen Vorrichtung der gesamte Kabelbaum sehr schnell und effizient geprüft werden.

Detektiert die Prüfeinheit an einem Kontakt lediglich die Frequenz, welche dem Netzwerk entspricht, zu welchem der Kontakt gehört, ist die Verbindung des Kontakts fehlerfrei. Trifft dies für alle Kontakte eines Netzwerks zu, kann das Netzwerk als fehlerfrei qualifiziert werden. Trifft dies für alle Netzwerke des Kabelbaums zu, kann der gesamte Kabelbaum als fehlerfrei gekennzeichnet werden. Die Prüfeinheit kann beispielsweise eine entsprechende Information an eine übergeordnete Steuerung, beispielsweise einer Produktionsanlage, übermitteln. Eine entsprechende Information kann auch als Kennzeichnung am Kabelbaum aufgebracht werden.

In einer Ausführungsform kann die Prüfeinheit ausgebildet sein, zu prüfen, ob an den nicht durch die Koppelvorrichtung kontaktierten Kontakten Frequenzen anliegen, welche nicht in das Netzwerk des jeweiligen Kontakts eingespeist werden.

Detektiert die Prüfeinheit an einem Kontakt eine Frequenz, welche einem anderen Netzwerk zugeordnet ist, deutet dies beispielsweise auf eine Vertauschung der Kontakte hin. In Steckern beziehungsweise Buchsen mit mehreren Kontakten werden die Kontakte üblicherweise bereits mit Kabeln versehen eingesteckt beziehungsweise "eingepinnt". Dabei können insbesondere bei einer händischen Verarbeitung die Positionen einzelner Kontakte vertauscht werden.

Detektiert die Prüfeinheit an einem Kontakt also eine Frequenz, die an einem anderen Kontakt detektiert werden sollte, deutet dies auf eine Vertauschung zweier Kontakte hin. Dies kann die Prüfeinheit insbesondere erkennen, wenn an zwei Kontakten eines Steckers beziehungsweise einer Buchse ausschließlich die jeweils dem anderen Kontakt zugeordnete Frequenz detektiert wird. Eine solche Vertauschung kann die Prüfeinheit ebenfalls der oben erwähnten übergeordneten Einheit melden.

In einer Ausführungsform kann die Prüfeinheit ausgebildet sein, für die Kontakte, an welchen Frequenzen anliegen, welche nicht in das Netzwerk des jeweiligen Kontakts eingespeist werden, einen Koppelfaktor (manchmal auch als Kopplungsfaktor bezeichnet) zu den entsprechenden weiteren Netzwerken zu bestimmen.

Detektiert die Prüfeinheit mehr als eine Frequenz an einem der Kontakte, deutet dies auf eine Kopplung mindestens zweier der Netzwerke hin. An dem Kontakt kann dann die Frequenz detektiert werden, welche dem Netzwerk des Kontakts zugeordnet ist. Zusätzlich kann aber auch die Frequenz des weiteren Netzwerks detektiert werden, welches eine Kopplung mit dem Netzwerk des Kontakts aufweist.

Den Koppelfaktor kann die Prüfeinheit beispielsweise anhand der Amplituden der Signalanteile mit den entsprechenden Frequenzen bestimmen. Die Prüfeinheit kann beispielsweise im Frequenzbereich die Amplitude für die jeweiligen Frequenzanteile bestimmen. Ferner ist der Prüfeinheit bekannt, mit welcher Amplitude die Testsignale in die Netzwerke eingespeist werden. Folglich kann sie das Verhältnis aus empfangener Amplitude und eingespeister Amplitude sehr einfach berechnen.

Anhand des Koppelfaktors kann die Prüfeinheit feststellen, wie stark die Kopplung beziehungsweise wie groß der Widerstand zwischen den Netzwerken ist. Beispielsweise können einzelne Netzwerke bewusst miteinander gekoppelt werden. Insbesondere kann in der Prüfeinheit beispielsweise auch hinterlegt sein, durch welche Elemente die Netzwerke miteinander gekoppelt sind. Für Elemente wie Widerstände, Kondensatoren und/oder Spulen kann die Prüfeinheit dann bestimmen, ob der Koppelfaktor dem vorgesehen Element zumindest annähernd entspricht. Ferner kann die Prüfeinheit ab einer bestimmten Größe des Koppelfaktors einen Kurzschluss zwischen den entsprechenden Netzwerken erkennen.

In einer Ausführungsform kann die Prüfeinheit ausgebildet sein, für die Kontakte an welchen Frequenzen anliegen, welche nicht in das Netzwerk des jeweiligen Kontakts eingespeist werden, eine Phasenverschiebung der jeweiligen Frequenzen zu bestimmen.

Unter Phasenverschiebung der jeweiligen Frequenzen ist die Phasenverschiebung zwischen dem ursprünglich eingespeisten Testsignal und dem Anteil des empfangenen Signals zu verstehen, welcher die jeweilige Frequenz betriff. Kapazitive und induktive Elemente dämpfen ein frequenzbehaftetes Signal nicht nur. Vielmehr erzeugen solche Elemente auch eine Phasenverschiebung.

Wertet die Prüfeinheit also eine Phasenverschiebung zwischen einem eingespeisten Signal und dem empfangenen Signal aus, kann zwischen einer resistiven Kopplung und einer kapazitiven beziehungsweise induktiven Kopplung unterschieden werden. In Kombination mit der Auswertung des Koppelfaktors kann so sehr genau erfasst und ausgewertet werden, welche Netzwerke in dem Kabelbaum auf welche Art miteinander gekoppelt sind.

In einer Ausführungsform kann die Prüfeinheit ausgebildet sein, für den Kabelbaum eine Speicherstruktur zu speichern, welche für jeden der Kontakte eine Information über das mit dem jeweiligen Kontakt verbundene Netzwerk aufweist.

Die Speicherstruktur kann beispielsweise für jeden der Kontakte speichern, in welchem Kontaktelement, also Stecker beziehungsweise Buchse, des Kabelbaums der jeweilige Kontakt angeordnet ist. Ferner kann die Speicherstruktur für jeden der Kontakte speichern, mit welchem der Netzwerke der Kontakt gekoppelt ist.

Die Speicherstruktur kann diese Information beispielsweise basierend auf den Ausgängen oder Outputs der Koppelvorrichtung und den Eingängen beziehungsweise Inputs der Prüfeinheit speichern. So kann in der Speicherstruktur ein Abbild der Vorrichtung zum Prüfen des Kabelbaums beziehungsweise des momentanen Zustands der Vorrichtung erzeugt werden. Diese Information kann ferner regelmäßig, beispielsweise alle 50 µS, anhand aktueller Messungen aktualisiert werden.

In der Prozessteuerung beispielsweise einer Produktionsanlage kann eine solche Speicherstruktur besonders vorteilhaft ausgewertet und zur Steuerung der Produktionsanlage genutzt werden. Die Informationen zu den Ausgängen und Eingängen der Vorrichtung zum Prüfen des Kabelbaums können beispielsweise ähnlich den Informationen zu den Inputs und Outputs in einer SPS-Anlage genutzt und verarbeitet werden.

Die Zuordnung des Ist-Zustands der Vorrichtung beziehungsweise des Kabelbaums zum Soll-Zustand ist dann nur noch eine Speicheroperation beispielsweise in einem übergeordneten Prüfrechner.

In einer Ausführungsform kann die Vorrichtung einen kontaktlosen beweglichen Signalsensor aufweisen, welcher ausgebildet ist, kontaktlos Signale in Leitungen des Kabelbaums zu erfassen, wobei die Prüfeinheit ausgebildet sein kann, den Signalsensor derart zu steuern, dass dieser über den Leitungen bewegt wird und auszuwerten, ob die den jeweiligen Leitungen entsprechenden Signale erfasst werden.

Der Signalsensor kann beispielsweise ein Hall-Sensor oder ein induktiver Sensor oder dergleichen sein, der auch ohne direkten Kontakt zu einer Leitung das Signal in der Leitung erfassen kann. Zur Bewegung des Signalsensors kann beispielsweise ein Roboterarm oder ein verfahrbares Portal oder dergleichen genutzt werden.

Üblicherweise werden Kabelbäume auf sogenannten Montagebrettern aufgebaut, auf welchen der jeweilige Kabelbaum Stück für Stück in seiner eigentlichen Form und Ausdehnung aufgebaut wird. Der Prüfeinheit kann diese Form beziehungsweise Ausdehnung bekannt sein. Folglich ist in der Prüfeinheit auch bekannt, welche Leitung des Kabelbaums sich an welcher Position auf dem Montagebrett befindet.

Fährt die Prüfeinheit nun mit dem Signalsensor die Leitungen des Kabelbaums ab, kann sie prüfen, ob die zu erwartenden Signale auch tatsächlich an den erwarteten Stellen vorhanden sind.

Die obige Beschreibung bezieht sich vorrangig auf elektrische Netzwerke. Es kann sich bei den Kontakten also um elektrische Kontakte handeln und die Testsignale beziehungsweise gemessen Signale können elektrische Signale sein.

Es versteht sich, dass die hier beschriebene Erfindung aber nicht auf die Anwendung in elektrischen Netzwerken beschränkt ist. Vielmehr können anstelle elektrischer Netzwerke auch optische Netzwerke geprüft werden. In diesem Fällen handelt es sich bei den Testsignalen um optische Signale und bei den Kontakten um optische Kontaktbeziehungsweise Koppelelemente. Die Erfindung kann ferner beispielsweise auch zur Erfassung von Druckverteilungen genutzt werden.

### Kurze Figurenbeschreibung

Nachfolgend werden vorteilhafte Ausführungsbeispiele der Erfindung unter Bezugnahme auf die begleitenden Figuren erläutert. Es zeigen:
- Figur 1: ein Blockschaltbild eines Ausführungsbeispiels einer Vorrichtung gemäß der vorliegenden Erfindung;
- Figur 2: ein Blockschaltbild eines weiteren Ausführungsbeispiels einer Vorrichtung gemäß der vorliegenden Erfindung;
- Figur 3: ein Ablaufdiagramm eines Ausführungsbeispiels eines Verfahrens gemäß der vorliegenden Erfindung; und
- Figur 4: ein Ablaufdiagramm eines Ausführungsbeispiels eines Herstellverfahrens gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

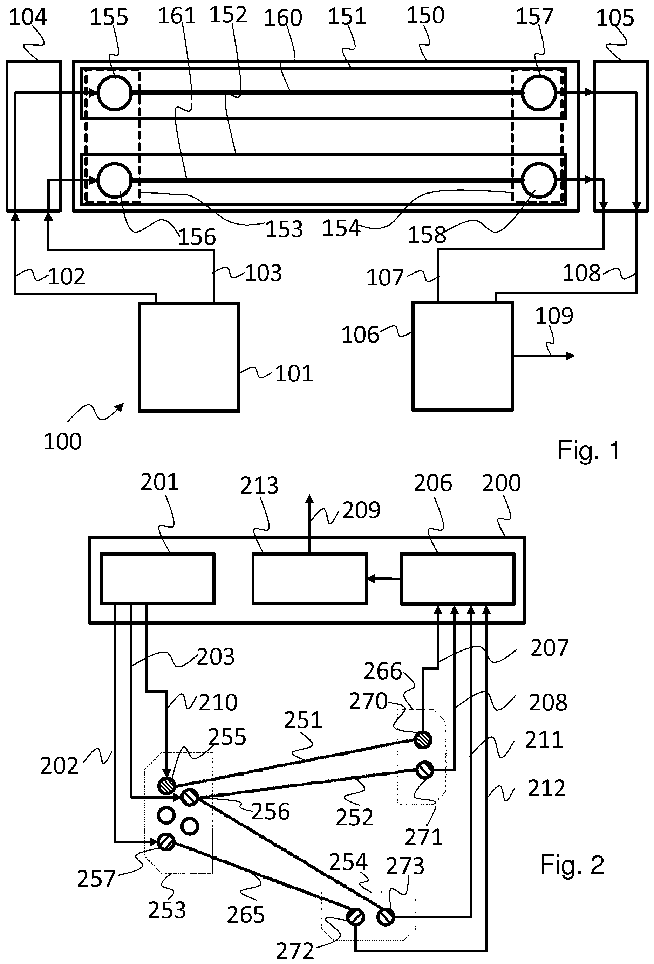

Figur 1 zeigt ein Blockschaltbild einer Vorrichtung 100. Die Vorrichtung 100 dient der Prüfung eines Kabelbaums 150 mit einer Vielzahl von Netzwerken 151, 152. In Figur 1 sind beispielhaft zwei Netzwerke 151, 152 gezeigt, welche durch Stecker 153, 154 mit einzelnen Kontakten 155, 156, 157, 158 gebildet werden, die durch Leitungen 160, 161 miteinander verbunden sind. In dem Stecker 153 sind die Kontakte 155, 156 angeordnet und in dem Stecker 154 sind die Kontakte 157, 158 angeordnet. Es versteht sich, dass die vorliegende Erfindung auch auf Kabelbäume mit mehr als zwei Netzwerken 151, 152 angewendet werden kann.

Die Vorrichtung 100 weist einen Signalgenerator 101 auf, der über eine Koppelvorrichtung 104 mit dem ersten Stecker 153 des Kabelbaums 150 verbunden ist. Der zweite Stecker 154 des Kabelbaums 150 ist über eine zweite Koppelvorrichtung 105 mit einer Prüfeinheit 106 gekoppelt.

Der Signalgenerator 101 erzeugt für jedes der Netzwerke 151, 152 ein Testsignal 102, 103 mit einer vorgegebenen Frequenz. Die Frequenzen der Testsignale 102, 103 sind also dem jeweiligen Netzwerk 151, 152 eindeutig zuzuordnen.

Die Testsignale 102, 103 werden über die Koppelvorrichtung 104 in das jeweilige Netzwerk 151, 152 eingespeist. Durch die Netzwerke 151, 152 werden die Testsignale 102, 103 dann zu den Kontakten 157, 158 in dem zweiten Stecker 154 geleitet. In dem zweiten Stecker werden die eingespeisten Testsignale 102, 103 über die zweite Koppelvorrichtung 105 als Prüfsignale 107, 108 an die Prüfeinheit 106 geleitet, wo sie ausgewertet werden.

Beim Auswerten durch die Prüfeinheit 106 kann diese prüfen, ob das Testsignal 102, 103 mit der jeweiligen Frequenz an den Kontakten 157, 158 anliegt.

Die Prüfeinheit 106 kann beispielsweise auch prüfen, ob an einem der Kontakte 157, 158 Frequenzen anliegen, welche nicht in das jeweilige Netzwerk 151, 152 eingespeist werden. Liegt also beispielsweise an dem Kontakt 157 die Frequenz des Signals 103 an oder an dem Kontakt 158 die Frequenz des Signals 102, liegt eine Kopplung zwischen zwei Netzwerken 151, 152 vor. Die Prüfeinheit 106 kann eine solche erkannte Kopplung beispielsweise als Prüfergebnis 109 an eine übergeordnete Steuereinheit weiterleiten. Wird keine Kopplung erkannt, kann die Prüfeinheit 106 das selbstverständlich auch an die übergeordnete Steuereinheit weiterleiten.

Die Prüfeinheit 106 kann für die Kontakte 157, 158 an welchen Frequenzen anliegen, welche nicht in das Netzwerk 151, 152 des jeweiligen Kontakts 157, 158 eingespeist werden, einen Koppelfaktor zu den entsprechenden weiteren Netzwerken 151, 152 bestimmen. Zusätzlich kann die Prüfeinheit 106 auch eine Phasenverschiebung der jeweiligen Frequenzen bestimmen. Dies ermöglicht der Prüfeinheit 106 die Kopplung näher zu charakterisieren und beispielsweise festzustellen, ob es sich um eine resistive, kapazitive oder induktive Kopplung handelt.

Es versteht sich, dass der Signalgenerator 101 und die Prüfeinheit 106 beispielsweise eine digitale Steuerlogik, beispielsweise einen Mikrocontroller oder dergleichen, und entsprechende analoge Signalaufbereitungs- beziehungsweise Signalverarbeitungselemente aufweisen können. Ferner können zumindest Teile des Signalgenerators 101 und der Prüfeinheit 106 in einem übergeordneten Steuerrechner angeordnet sein.

Figur 2 zeigt ein Blockschaltbild einer weiteren Vorrichtung 200 zum Prüfen eines Kabelbaums. Der Kabelbaum ist in Figur 2 nicht separat bezeichnet, wird aber durch die Stecker 253, 254, 266 repräsentiert, welche drei elektrische Netzwerke 251, 252, 265 aufspannen. In dem Stecker 253 sind der elektrische Kontakt 255, der elektrische Kontakt 256 und der elektrische Kontakt 257 angeordnet. Zwei weitere Kontakte des Steckers 253 sind nicht genutzt. In dem Stecker 266 sind der elektrische Kontakt 270 und der elektrische Kontakt 271 angeordnet. In dem Stecker 254 sind der elektrische Kontakt 272 und der elektrische Kontakt 273 angeordnet. Die Kontakte 255 und 270 bilden das elektrische Netzwerk 251, die Kontakte 256, 271 und 273 bilden das elektrische Netzwerk 252 und die elektrischen Kontakte 257 und 272 bilden das elektrische Netzwerk 265.

Die Vorrichtung 200 ist als eine integrierte Vorrichtung 200 ausgebildet. Es sind also alle Elemente der Vorrichtung 200 gemeinsam, beispielsweise in einer Steuerung einer Produktionsanlage oder einem Prüfrechner, angeordnet. Die Vorrichtung 200 weist einen Signalgenerator 101 auf, der die Testsignale 202, 203 und 210 erzeugt und an die elektrischen Kontakte 257, 256 und 255 ausgibt. An den elektrischen Kontakten 270, 271, 272 und 273 nimmt die Prüfeinheit 206 die in den elektrischen Netzwerken 251, 252, 265 übertragenen Testsignale 202, 203, 210 auf und analysiert diese. Es wird deutlich, dass die Prüfeinheit 206 an allen elektrischen Kontakten 270, 271, 272 und 273 die dort jeweils empfangenen Signale aufnehmen kann, auch wenn mehrere der elektrischen Kontakte 270, 271, 272 und 273 zu dem gleichen elektrischen Netzwerk 251, 252, 265 gehören.

Die Prüfeinheit 206 kann auf die erfassten Signale analog diejenigen Analysen anwenden, welche bereits oben in Zusammenhang mit der Prüfeinheit 106 beschrieben wurden. Die Prüfeinheit 206 kann also beispielsweise prüfen, ob an allen elektrischen Kontakten 270, 271, 272 und 273 Signale mit der in das jeweilige elektrische Netzwerk 251, 252, 265 eingespeisten Frequenz anliegen. Für den Fall, dass zusätzlich die Signale anderer elektrischer Netzwerke 251, 252, 265 anliegen, kann die Prüfeinheit 206 zusätzlich einen Koppelfaktor für diese Signale beziehungsweise Netzwerke 251, 252, 265 und eine Phasenverschiebung für diese Signale berechnen.

Die Prüfeinheit 206 der Vorrichtung 200 erzeugt basierend auf den Prüfergebnissen eine Speicherstruktur 213. Die Speicherstruktur 213 speichert für jeden der Kontakte 255, 256, 257, 270, 271, 272, 273 zumindest eine Information über das mit dem jeweiligen Kontakt 255, 256, 257, 270, 271, 272, 273 verbundene elektrische Netzwerk 251, 252, 265. Diese Information kann beispielsweise basierend auf einer an dem jeweiligen Kontakt 255, 256, 257, 270, 271, 272, 273 eingespeisten oder gemessenen Frequenz bestimmt werden. Es versteht sich, dass die Speicherstruktur 213 zusätzliche Informationen speichern kann. Solche Informationen können beispielsweise zusätzliche an einem Kontakt 255, 256, 257, 270, 271, 272, 273 gemessene Frequenzen und die Phasenverschiebungen zwischen den jeweils eingespeisten Testsignalen 202, 203, 210 und den gemessen Signalen mit den zusätzlichen Frequenzen betreffen.

Die Speicherstruktur 213 kann dann als das Prüf- oder Testergebnis 209 ausgegeben werden. Ein übergeordneter Steuerrechner kann diese Information dann verarbeiten. Bei einer automatisierten Produktionsanlage kann der übergeordnete Steuerrechner die Produktionsanlage derart steuern, dass beispielsweise fehlerhaft gesetzte elektrische Kontakte 255, 256, 257, 270, 271, 272, 273 ausgetauscht werden.

Wird die Produktion des Kabelbaums manuell oder teilweise manuell durchgeführt, kann den Benutzern bei einer fehlerhaften Verkabelung der einzelnen Netzwerke 251, 252, 265 eine Information darüber übermittelt werden, wo der Fehler zu finden ist. Beispielsweise kann den Benutzern angezeigt werden, in welchem Stecker 253, 254, 266 welche Kontakte 255, 256, 257, 270, 271, 272, 273 getauscht werden müssen, um einen Fehler zu beseitigen. Liegt eine unerwünschte Kopplung, also beispielsweise ein Kurzschluss, zwischen zwei der elektrischen Netzwerke 251, 252, 265 vor, kann den Benutzern beispielsweise auch angezeigt werden, welche Segmente des Kabelbaums die Benutzer prüfen müssen.

Insbesondere bei der automatisierten Produktion aber auch bei der manuellen oder teilmanuellen Produktion des Kabelbaums kann auch ein beweglicher Signalsensor vorgesehen sein (nicht dargestellt). Der bewegliche Signalsensor kann kontaktlos Signale in Leitungen des Kabelbaums erfassen. Die Prüfeinheit 206 kann den Signalsensor beispielsweise derart steuern, dass dieser über den Leitungen bewegt wird, und auswerten, ob die den jeweiligen Leitungen entsprechenden Signale tatsächlich erfasst werden.

Zum leichteren Verständnis werden in der folgenden Beschreibung die Bezugszeichen zu den Figuren 1 und 2 als Referenz beibehalten.

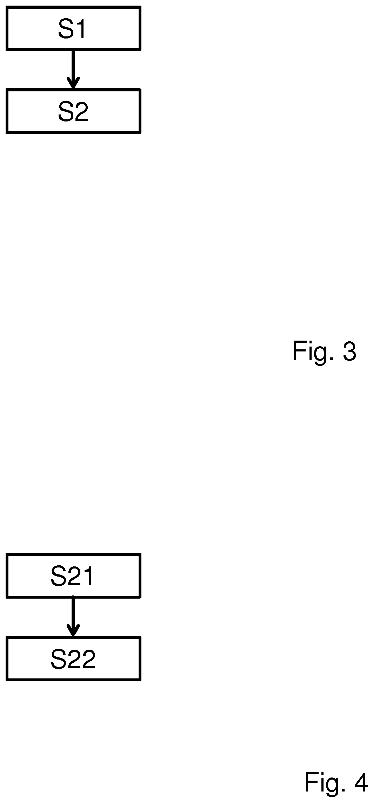

Das Verfahren gemäß Figur 3 dient dem Prüfen eines Kabelbaums 150 mit einer Vielzahl von Netzwerken 151, 152, 251, 252, 265, welche durch Verbindungselemente 153, 154, 253, 254, 266 mit einzelnen Kontakten 155, 156, 157, 158, 255, 256, 257, 270, 271, 272, 273, die durch Leitungen 160, 161 miteinander gekoppelt sind, gebildet werden.

In einem ersten Schritt S1 des Einspeisens wird ein Testsignal 102, 103, 202, 203, 210 einer vorgegebenen Frequenz in mindestens eines der Netzwerke 151, 152, 251, 252, 265 über einen der Kontakte 155, 156, 157, 158, 255, 256, 257, 270, 271, 272, 273 des Netzwerks 151, 152, 251, 252, 265 eingespeist. In einem zweiten Schritt S2 des Prüfens werden die weiteren Kontakte 155, 156, 157, 158, 255, 256, 257, 270, 271, 272, 273, welche dem mindestens einen Netzwerk 151, 152, 251, 252, 265 zugeordnet sind, auf das Vorhandensein des Testsignals 102, 103, 202, 203, 210 überprüft.

Das Verfahren kann ferner einen Schritt des Erzeugens aufweisen, in welchem ein Testsignal 102, 103, 202, 203, 210 mit einer vorgegebenen Frequenz für jedes der Netzwerke 151, 152, 251, 252, 265 erzeugt wird. Beim Einspeisen S1 kann jedes der Netzwerke 151, 152, 251, 252, 265 kontaktiert werden und das entsprechende Testsignal 102, 103, 202, 203, 210 in jedes der Netzwerke 151, 152, 251, 252, 265 eingespeist werden. Beim Schritt des Prüfen S2 können folglich, an den nicht für die Einspeisung genutzten Kontakten 155, 156, 157, 158, 255, 256, 257, 270, 271, 272, 273, die Frequenzen ermittelt werden, welche in den Signalen enthalten sind, welche an den Kontakten 155, 156, 157, 158, 255, 256, 257, 270, 271, 272, 273 jeweils anliegen.

Ferner kann beim Prüfen S2 geprüft werden, ob an den nicht kontaktierten Kontakten 155, 156, 157, 158, 255, 256, 257, 270, 271, 272, 273 Frequenzen anliegen, welche nicht in das Netzwerk 151, 152, 251, 252, 265 des jeweiligen Kontakts 155, 156, 157, 158, 255, 256, 257, 270, 271, 272, 273 eingespeist werden. Sind solche Frequenzen vorhanden, kann beim Prüfen S2 für die Kontakte 155, 156, 157, 158, 255, 256, 257, 270, 271, 272, 273 an welchen solche Frequenzen anliegen, ein Koppelfaktor zu den entsprechenden weiteren Netzwerken 151, 152, 251, 252, 265 bestimmt werden. Ferner kann für die Signale mit diesen Frequenzen auch eine Phasenverschiebung bestimmt werden.

Zur einfacheren Auswertung kann das Verfahren ferner das Anlegen einer Speicherstruktur 213 aufweisen, welche für jeden der Kontakte 155, 156, 157, 158, 255, 256, 257, 270, 271, 272, 273 eine Information über das mit dem jeweiligen Kontakt 155, 156, 157, 158, 255, 256, 257, 270, 271, 272, 273 verbundene Netzwerk 151, 152, 251, 252, 265 aufweist. Ferner kann eine Information über alle weiteren als gekoppelt erkannten Netzwerke gespeichert werden.

Schließlich kann das Verfahren auch das kontaktlose Erfassen von Signalen in Leitungen 160, 161 des Kabelbaums 150 aufweisen, wobei beim Prüfen S2 ausgewertet wird, ob die den jeweiligen Leitungen 160, 161 entsprechenden Signale an den erwarteten Positionen erfasst werden.

In Figur 4 wird ein Herstellverfahren für einen Kabelbaum 150 mit einer Vielzahl von Netzwerken 151, 152, 251, 252, 265, welche durch Verbindungselemente 153, 154, 253, 254, 266 mit einzelnen Kontakten 155, 156, 157, 158, 255, 256, 257, 270, 271, 272, 273, die durch Leitungen 160, 161 miteinander gekoppelt sind, gebildet werden, gezeigt.

In einem ersten Schritt S21 des Verbindens werden einzelne Kontakte 155, 156, 157, 158, 255, 256, 257, 270, 271, 272, 273 der Verbindungselemente 153, 154, 253, 254, 266 mit Hilfe von Leitungen 160, 161 verbunden, um die Netzwerke 151, 152, 251, 252, 265 in dem Kabelbaum 150 auszubilden. In einem zweiten Schritt S22 des Prüfens wird der Kabelbaum 150 gemäß dem erfindungsgemäßen Verfahren zum Prüfen eines Kabelbaums 150 geprüft. Um Wiederholungen zu vermeiden sei hier auf die Beschreibung zur Figur 3 verwiesen.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

### BEZUGSZEICHENLISTE

- 100, 200: Vorrichtung
- 101, 201: Signalgenerator
- 102, 103, 202, 203, 210: Testsignal
- 104, 105: Koppelvorrichtung
- 106, 206: Prüfeinheit
- 107, 108, 207, 208, 211, 212: Prüfsignal
- 109, 209: Prüfergebnis

- 213: Speicherstruktur

- 150: Kabelbaum
- 151, 152, 251, 252, 265: Netzwerk
- 153, 154, 253, 254, 266: Verbindungselemente
- 155, 156, 157, 158: Kontakte
- 255, 256, 257, 270, 271, 272, 273: Kontakte
- 160, 161: Leitungen

- S1, S2, S21, S22: Verfahrensschritte

## Patentansprüche

1. Vorrichtung (100, 200) zum Prüfen eines Kabelbaums (150) mit einer Vielzahl von Netzwerken (151, 152, 251, 252, 265), welche durch Verbindungselemente (153, 154, 253, 254, 266) mit einzelnen Kontakten (155, 156, 157, 158, 255, 256, 257, 270, 271, 272, 273), die durch Leitungen (160, 161) miteinander gekoppelt sind, gebildet werden, mit:
einem Signalgenerator (101, 201), welcher ausgebildet ist, mindestens ein Testsignal (102, 103, 202, 203, 210) mit einer vorgegebenen Frequenz zu erzeugen,
einer Koppelvorrichtung (104, 105), welche ausgebildet ist, mindestens eines der Netzwerke (151, 152, 251, 252, 265) über einen der Kontakte (155, 156, 157, 158, 255, 256, 257, 270, 271, 272, 273) des Netzwerks (151, 152, 251, 252, 265) zu kontaktieren und das Testsignal (102, 103, 202, 203, 210) in das entsprechende Netzwerk (151, 152, 251, 252, 265) einzuspeisen, und
einer Prüfeinheit (106, 206), welche ausgebildet ist, die weiteren Kontakte (155, 156, 157, 158, 255, 256, 257, 270, 271, 272, 273) des mindestens einen Netzwerks (151, 152, 251, 252, 265) zu kontaktieren und zu prüfen, ob das Testsignal (102, 103, 202, 203, 210) mit der jeweiligen Frequenz an den weiteren Kontakten (155, 156, 157, 158, 255, 256, 257, 270, 271, 272, 273) anliegt;
wobei der Signalgenerator (101, 201) ausgebildet ist, für jedes der Netzwerke (151, 152, 251, 252, 265) ein Testsignal (102, 103, 202, 203, 210) mit einer vorgegebenen Frequenz zu erzeugen,
wobei die Koppelvorrichtung (104, 105) ausgebildet ist, jedes der Netzwerke (151, 152, 251, 252, 265) zu kontaktieren und das entsprechende Testsignal (102, 103, 202, 203, 210) in jedes der Netzwerke (151, 152, 251, 252, 265) einzuspeisen, und
wobei die Prüfeinheit (106, 206) ausgebildet ist, an den nicht durch die Koppelvorrichtung (104, 105) kontaktierten Kontakten (155, 156, 157, 158, 255, 256, 257, 270, 271, 272, 273), die Frequenzen zu ermitteln, welche in den Signalen enthalten sind, welche an den Kontakten (155, 156, 157, 158, 255, 256, 257, 270, 271, 272, 273) jeweils anliegen;
**dadurch gekennzeichnet, dass** die Prüfeinheit (106, 206) ausgebildet ist, zu prüfen, ob an den nicht durch die Koppelvorrichtung (104, 105) kontaktierten Kontakten (155, 156, 157, 158, 255, 256, 257, 270, 271, 272, 273) Frequenzen anliegen, welche nicht in das Netzwerk (151, 152, 251, 252, 265) des jeweiligen Kontakts (155, 156, 157, 158, 255, 256, 257, 270, 271, 272, 273) eingespeist werden;
wobei die Prüfeinheit (106, 206) ausgebildet ist, für die Kontakte (155, 156, 157, 158, 255, 256, 257, 270, 271, 272, 273) an welchen Frequenzen anliegen, welche nicht in das Netzwerk (151, 152, 251, 252, 265) des jeweiligen Kontakts (155, 156, 157, 158, 255, 256, 257, 270, 271, 272, 273) eingespeist werden, einen Koppelfaktor zu den entsprechenden weiteren Netzwerken (151, 152, 251, 252, 265) zu bestimmen.

2. Vorrichtung (100, 200) gemäß Anspruch 1, wobei die Prüfeinheit (106, 206) ausgebildet ist, für die Kontakte (155, 156, 157, 158, 255, 256, 257, 270, 271, 272, 273) an welchen Frequenzen anliegen, welche nicht in das Netzwerk (151, 152, 251, 252, 265) des jeweiligen Kontakts (155, 156, 157, 158, 255, 256, 257, 270, 271, 272, 273) eingespeist werden, eine Phasenverschiebung der jeweiligen Frequenzen zu bestimmen.

3. Vorrichtung (100, 200) gemäß einem der vorherigen Ansprüche, wobei die Prüfeinheit (106, 206) ausgebildet ist, für den Kabelbaum (150) eine Speicherstruktur (213) zu speichern, welche für jeden der Kontakte (155, 156, 157, 158, 255, 256, 257, 270, 271, 272, 273) eine Information über das mit dem jeweiligen Kontakt (155, 156, 157, 158, 255, 256, 257, 270, 271, 272, 273) verbundene Netzwerk (151, 152, 251, 252, 265) aufweist.

4. Vorrichtung (100, 200) gemäß einem der vorherigen Ansprüche, aufweisend einen kontaktlosen beweglichen Signalsensor, welcher ausgebildet ist, kontaktlos Signale in Leitungen (160, 161) des Kabelbaums (150) zu erfassen, wobei die Prüfeinheit (106, 206) ausgebildet ist, den Signalsensor derart zu steuern, dass dieser über den Leitungen (160, 161) bewegt wird und auszuwerten, ob die den jeweiligen Leitungen (160, 161) entsprechenden Signale erfasst werden.

5. Verfahren zum Prüfen eines Kabelbaums (150) mit einer Vielzahl von Netzwerken (151, 152, 251, 252, 265), welche durch Verbindungselemente (153, 154, 253, 254, 266) mit einzelnen Kontakten (155, 156, 157, 158, 255, 256, 257, 270, 271, 272, 273), die durch Leitungen (160, 161) miteinander gekoppelt sind, gebildet werden, wobei das Verfahren die folgenden Schritte aufweist:
Einspeisen (S1) eines Testsignals (102, 103, 202, 203, 210) einer vorgegebenen Frequenz in mindestens eines der Netzwerke (151, 152, 251, 252, 265) über einen der Kontakte (155, 156, 157, 158, 255, 256, 257, 270, 271, 272, 273) des Netzwerks (151, 152, 251, 252, 265), und
Prüfen (S2) der weiteren Kontakte (155, 156, 157, 158, 255, 256, 257, 270, 271, 272, 273), welche dem mindestens einen Netzwerk (151, 152, 251, 252, 265) zugeordnet sind, auf das Vorhandensein des Testsignals (102, 103, 202, 203, 210);
Erzeugen eines Testsignals (102, 103, 202, 203, 210) mit einer vorgegebenen Frequenz für jedes der Netzwerke (151, 152, 251, 252, 265),
wobei beim Einspeisen (S1) jedes der Netzwerke (151, 152, 251, 252, 265) kontaktiert wird und das entsprechende Testsignal (102, 103, 202, 203, 210) in jedes der Netzwerke (151, 152, 251, 252, 265) eingespeist wird, und
wobei beim Prüfen (S2), an den nicht für die Einspeisung genutzten Kontakten (155, 156, 157, 158, 255, 256, 257, 270, 271, 272, 273), die Frequenzen ermittelt werden, welche in den Signalen enthalten sind, welche an den Kontakten (155, 156, 157, 158, 255, 256, 257, 270, 271, 272, 273) jeweils anliegen;
**dadurch gekennzeichnet, dass** beim Prüfen (S2) geprüft wird, ob an den nicht kontaktierten Kontakten (155, 156, 157, 158, 255, 256, 257, 270, 271, 272, 273) Frequenzen anliegen, welche nicht in das Netzwerk (151, 152, 251, 252, 265) des jeweiligen Kontakts (155, 156, 157, 158, 255, 256, 257, 270, 271, 272, 273) eingespeist werden; und
wobei beim Prüfen (S2) für die Kontakte (155, 156, 157, 158, 255, 256, 257, 270, 271, 272, 273) an welchen Frequenzen anliegen, welche nicht in das Netzwerk (151, 152, 251, 252, 265) des jeweiligen Kontakts (155, 156, 157, 158, 255, 256, 257, 270, 271, 272, 273) eingespeist werden, einen Koppelfaktor zu den entsprechenden weiteren Netzwerken (151, 152, 251, 252, 265) bestimmt wird.

6. Verfahren gemäß Anspruch 5, wobei beim Prüfen (S2) für die Kontakte (155, 156, 157, 158, 255, 256, 257, 270, 271, 272, 273) an welchen Frequenzen anliegen, welche nicht in das Netzwerk (151, 152, 251, 252, 265) des jeweiligen Kontakts (155, 156, 157, 158, 255, 256, 257, 270, 271, 272, 273) eingespeist werden, eine Phasenverschiebung der jeweiligen Frequenzen bestimmt wird.

7. Verfahren gemäß einem der vorherigen Ansprüche 5 und 6, wobei beim Prüfen (S2) für den Kabelbaum (150) eine Speicherstruktur (213) gespeichert wird, welche für jeden der Kontakte (155, 156, 157, 158, 255, 256, 257, 270, 271, 272, 273) eine Information über das mit dem jeweiligen Kontakt (155, 156, 157, 158, 255, 256, 257, 270, 271, 272, 273) verbundene Netzwerk (151, 152, 251, 252, 265) aufweist.

8. Verfahren gemäß einem der vorherigen Ansprüche 5 bis 7, aufweisend das kontaktlose Erfassen von Signalen in Leitungen (160, 161) des Kabelbaums (150), wobei beim Prüfen (S2) ausgewertet wird, ob die den jeweiligen Leitungen (160, 161) entsprechenden Signale an den erwarteten Positionen erfasst werden.

9. Herstellverfahren für einen Kabelbaum (150) mit einer Vielzahl von Netzwerken (151, 152, 251, 252, 265), welche durch Verbindungselemente (153, 154, 253, 254, 266) mit einzelnen Kontakten (155, 156, 157, 158, 255, 256, 257, 270, 271, 272, 273), die durch Leitungen (160, 161) miteinander gekoppelt sind, gebildet werden, wobei das Verfahren die folgenden Schritte aufweist:
Verbinden (S21) einzelner Kontakte (155, 156, 157, 158, 255, 256, 257, 270, 271, 272, 273) der Verbindungselemente (153, 154, 253, 254, 266) mit Hilfe von Leitungen (160, 161), um die Netzwerke (151, 152, 251, 252, 265) in dem Kabelbaum (150) auszubilden, und
Prüfen (S22) des Kabelbaums (150) gemäß dem Verfahren zum Prüfen eines Kabelbaums (150) nach einem der vorherigen Ansprüche 5 bis 8.

## Claims

1. Apparatus (100, 200) for testing a cable harness (150) having a multiplicity of networks (151, 152, 251, 252, 265), which are formed by connecting elements (153, 154, 253, 254, 266) having individual contacts (155, 156, 157, 158, 255, 256, 257, 270, 271, 272, 273), which are coupled to one another by lines (160, 161), having:
a signal generator (101, 201), which is designed to generate at least one test signal (102, 103, 202, 203, 210) at a prescribed frequency,
a coupling apparatus (104, 105), which is designed to contact-connect at least one of the networks (151, 152, 251, 252, 265) by means of one of the contacts (155, 156, 157, 158, 255, 256, 257, 270, 271, 272, 273) of the network (151, 152, 251, 252, 265) and to feed the test signal (102, 103, 202, 203, 210) into the corresponding network (151, 152, 251, 252, 265), and
a testing unit (106, 206), which is designed to contact-connect the further contacts (155, 156, 157, 158, 255, 256, 257, 270, 271, 272, 273) of the at least one network (151, 152, 251, 252, 265) and to test whether the test signal (102, 103, 202, 203, 210) at the respective frequency is applied to the further contacts (155, 156, 157, 158, 255, 256, 257, 270, 271, 272, 273);
wherein the signal generator (101, 201) is designed to generate a test signal (102, 103, 202, 203, 210) at a prescribed frequency for each of the networks (151, 152, 251, 252, 265),
wherein the coupling apparatus (104, 105) is designed to contact-connect each of the networks (151, 152, 251, 252, 265) and to feed the corresponding test signal (102, 103, 202, 203, 210) into each of the networks (151, 152, 251, 252, 265), and
wherein the testing unit (106, 206) is designed to ascertain the frequencies, which are contained in the signals applied to the respective contacts (155, 156, 157, 158, 255, 256, 257, 270, 271, 272, 273), at the contacts (155, 156, 157, 158, 255, 256, 257, 270, 271, 272, 273) that are not contact-connected by the coupling apparatus (104, 105);
**characterized in that**
the testing unit (106, 206) is designed to test whether frequencies, which are not fed into the network (151, 152, 251, 252, 265) of the respective contact (155, 156, 157, 158, 255, 256, 257, 270, 271, 272, 273), are applied to the contacts (155, 156, 157, 158, 255, 256, 257, 270, 271, 272, 273) that are not contact-connected by the coupling apparatus (104, 105);
wherein the testing unit (106, 206) is designed to determine a coupling factor with respect to the corresponding further networks (151, 152, 251, 252, 265) for the contacts (155, 156, 157, 158, 255, 256, 257, 270, 271, 272, 273) to which frequencies that are not fed into the network (151, 152, 251, 252, 265) of the respective contact (155, 156, 157, 158, 255, 256, 257, 270, 271, 272, 273) are applied.

2. Apparatus (100, 200) according to Claim 1, wherein the testing unit (106, 206) is designed to determine a phase shift of the respective frequencies for the contacts (155, 156, 157, 158, 255, 256, 257, 270, 271, 272, 273) to which frequencies that are not fed into the network (151, 152, 251, 252, 265) of the respective contact (155, 156, 157, 158, 255, 256, 257, 270, 271, 272, 273) are applied.

3. Apparatus (100, 200) according to either of the preceding claims, wherein the testing unit (106, 206) is designed to store a storage structure (213) for the cable harness (150), which storage structure has, for each of the contacts (155, 156, 157, 158, 255, 256, 257, 270, 271, 272, 273), information about the network (151, 152, 251, 252, 265) that is connected to the respective contact (155, 156, 157, 158, 255, 256, 257, 270, 271, 272, 273).

4. Apparatus (100, 200) according to one of the preceding claims, having a contactless movable signal sensor, which is designed to detect signals in lines (160, 161) of the cable harness (150) in a contactless manner, wherein the testing unit (106, 206) is designed to control the signal sensor in such a way that it is moved over the lines (160, 161) and to evaluate whether the signals corresponding to the respective lines (160, 161) are detected.

5. Method for testing a cable harness (150) having a multiplicity of networks (151, 152, 251, 252, 265), which are formed by connecting elements (153, 154, 253, 254, 266) having individual contacts (155, 156, 157, 158, 255, 256, 257, 270, 271, 272, 273), which are coupled to one another by lines (160, 161), wherein the method has the following steps:
feeding (S1) a test signal (102, 103, 202, 203, 210) of a prescribed frequency into at least one of the networks (151, 152, 251, 252, 265) by means of one of the contacts (155, 156, 157, 158, 255, 256, 257, 270, 271, 272, 273) of the network (151, 152, 251, 252, 265), and
testing (S2) the further contacts (155, 156, 157, 158, 255, 256, 257, 270, 271, 272, 273) assigned to the at least one network (151, 152, 251, 252, 265) for the presence of the test signal (102, 103, 202, 203, 210);
generating a test signal (102, 103, 202, 203, 210) at a prescribed frequency for each of the networks (151, 152, 251, 252, 265),
wherein, during the infeed (S1), each of the networks (151, 152, 251, 252, 265) is contact-connected and the corresponding test signal (102, 103, 202, 203, 210) is fed into each of the networks (151, 152, 251, 252, 265), and
wherein, during testing (S2), the frequencies, which are contained in the signals applied to the respective contacts (155, 156, 157, 158, 255, 256, 257, 270, 271, 272, 273), are ascertained at the contacts (155, 156, 157, 158, 255, 256, 257, 270, 271, 272, 273) that are not used for the infeed;
**characterized in that**
during testing (S2), a test is carried out to determine whether frequencies, which are not fed into the network (151, 152, 251, 252, 265) of the respective contact (155, 156, 157, 158, 255, 256, 257, 270, 271, 272, 273), are applied to the non-contact-connected contacts (155, 156, 157, 158, 255, 256, 257, 270, 271, 272, 273); and
wherein during testing (S2), a coupling factor is determined with respect to the corresponding further networks (151, 152, 251, 252, 265) for the contacts (155, 156, 157, 158, 255, 256, 257, 270, 271, 272, 273) to which frequencies that are not fed into the network (151, 152, 251, 252, 265) of the respective contact (155, 156, 157, 158, 255, 256, 257, 270, 271, 272, 273) are applied.

6. Method according to Claim 5, wherein, during testing (S2), a phase shift of the respective frequencies is determined for the contacts (155, 156, 157, 158, 255, 256, 257, 270, 271, 272, 273) to which frequencies that are not fed into the network (151, 152, 251, 252, 265) of the respective contact (155, 156, 157, 158, 255, 256, 257, 270, 271, 272, 273) are applied.

7. Method according to either of the preceding Claims 5 and 6, wherein, during testing (S2), a storage structure (213) is stored for the cable harness (150), which storage structure has, for each of the contacts (155, 156, 157, 158, 255, 256, 257, 270, 271, 272, 273), information about the network (151, 152, 251, 252, 265) that is connected to the respective contact (155, 156, 157, 158, 255, 256, 257, 270, 271, 272, 273).

8. Method according to one of the preceding Claims 5 to 7, having the contactless detection of signals in lines (160, 161) of the cable harness (150), wherein, during testing (S2), an evaluation is carried out as to whether the signals corresponding to the respective lines (160, 161) are detected at the expected positions.

9. Production method for a cable harness (150) having a multiplicity of networks (151, 152, 251, 252, 265), which are formed by connecting elements (153, 154, 253, 254, 266) having individual contacts (155, 156, 157, 158, 255, 256, 257, 270, 271, 272, 273), which are coupled to one another by lines (160, 161), wherein the method has the following steps:
connecting (S21) individual contacts (155, 156, 157, 158, 255, 256, 257, 270, 271, 272, 273) of the connecting elements (153, 154, 253, 254, 266) with the aid of lines (160, 161) in order to form the networks (151, 152, 251, 252, 265) in the cable harness (150), and
testing (S22) the cable harness (150) in accordance with the method for testing a cable harness (150) according to one of the preceding Claims 5 to 8.

## Revendications

1. Dispositif (100, 200) pour tester un faisceau de câbles (150) comprenant une pluralité de réseaux (151, 152, 251, 251, 252, 265) qui sont formés par des éléments de connexion (153, 154, 253, 254, 266) munis de contacts (155, 156, 157, 158, 255, 256, 257, 270, 271, 272, 273) individuels couplés les uns aux autres par des lignes (160, 161) et comprenant :
un générateur de signal (101, 201) qui est conçu pour générer au moins un signal de test (102, 103, 202, 203, 210) ayant une fréquence prédéterminée,
un dispositif de couplage (104, 105) qui est conçu pour établir un contact avec au moins l'un des réseaux (151, 152, 251, 252, 252, 265) par l'intermédiaire de l'un des contacts (155, 156, 157, 158, 255, 256, 257, 270, 271, 272, 273) du réseau (151, 152, 251, 252, 265) et pour injecter le signal de test (102, 103, 202, 203, 210) dans le réseau (151, 152, 251, 252, 265) correspondant, et une unité de test (106, 206) qui est conçue pour établir un contact avec les autres contacts (155, 156, 157, 158, 255, 256, 257, 270, 271, 272, 273) dudit au moins un réseau (151, 152, 251, 252, 265) et pour tester si le signal de test (102, 103, 202, 203, 210) ayant la fréquence respective est présent sur les autres contacts (155, 156, 157, 158, 255, 256, 257, 270, 271, 272, 273) ; dans lequel le générateur de signal (101, 201) est conçu pour générer, pour chacun des réseaux (151, 152, 251, 252, 265), un signal test (102, 103, 202, 203, 210) ayant une fréquence prédéterminée,
dans lequel le dispositif de couplage (104, 105) est conçu pour établir un contact avec chacun des réseaux (151, 152, 251, 252, 265) et pour injecter le signal de test (102, 103, 202, 203, 210) correspondant dans chacun des réseaux (151, 152, 251, 252, 265), et
dans lequel l'unité de test (106, 206) est conçue pour déterminer, sur les contacts (155, 156, 157, 158, 255, 256, 257, 270, 271, 272, 273) avec lesquels aucun contact n'est établi par le dispositif de couplage (104, 105), les fréquences qui sont contenues dans les signaux respectivement présents sur les contacts (155, 156, 157, 158, 255, 256, 257, 270, 271, 272, 273) ;
**caractérisé en ce que** l'unité de test (106, 206) est conçue pour tester si des fréquences qui ne sont pas injectées dans le réseau (151, 152, 251, 252, 265) du contact (155, 156, 157, 158, 255, 256, 257, 270, 271, 272, 273) respectif sont présentes sur les contacts (155, 156, 157, 158, 255, 256, 257, 270, 271, 272, 273) avec lesquels aucun contact n'est établi par le dispositif de couplage (104, 105) ;
dans lequel l'unité de test (106, 206) est conçue, pour les contacts (155, 156, 157, 158, 255, 256, 257, 270, 271, 272, 273) sur lesquels sont présentes des fréquences qui ne sont pas injectées dans le réseau (151, 152, 251, 252, 265) du contact (155, 156, 157, 158, 255, 256, 257, 270, 271, 272, 273) respectif, pour déterminer un facteur de couplage avec les autres réseaux (151, 152, 251, 252, 265) correspondants.

2. Dispositif (100, 200) selon la revendication 1, dans lequel l'unité de test (106, 206) est conçue, pour les contacts (155, 156, 157, 158, 255, 256, 257, 270, 271, 272, 273) sur lesquels sont présentes des fréquences qui ne sont pas injectées dans le réseau (151, 152, 251, 252, 265) du contact (155, 156, 157, 158, 255, 256, 257, 270, 271, 272, 273) respectif, pour déterminer un déphasage des fréquences respectives.

3. Dispositif (100, 200) selon l'une des revendications précédentes, dans lequel l'unité de test (106, 206) est conçue pour stocker, pour le faisceau de câbles (150), une structure de mémoire (213) qui comporte, pour chacun des contacts (155, 156, 157, 158, 255, 256, 257, 270, 271, 272, 273), une informations concernant le réseau (151, 152, 251, 252, 265) connecté au contact (155, 156, 157, 158, 255, 256, 257, 270, 271, 272, 273) respectif.

4. Dispositif (100, 200) selon l'une des revendications précédentes, comportant un capteur de signal mobile sans contact conçu pour détecter des signaux sans contact sur des lignes (160, 161) du faisceau de câbles (150), dans lequel l'unité de test (106, 206) est conçue pour commander le capteur de signal de manière à ce qu'il soit déplacé sur les lignes (160, 161) et pour évaluer si les signaux correspondant aux lignes (160, 161) respectives sont détectés.

5. Procédé de test d'un faisceau de câbles (150) comprenant une pluralité de réseaux (151, 152, 251, 252, 265) qui sont formés par des éléments de connexion (153, 154, 253, 254, 266) munis de contacts (155, 156, 157, 158, 255, 256, 257, 270, 271, 272, 273) individuels couplés les uns aux autres par des lignes (160, 161), dans lequel le procédé comprend les étapes suivantes : l'injection (S1) d'un signal de test (102, 103, 202, 203, 210) ayant une fréquence prédéterminée dans au moins l'un des réseaux (151, 152, 251, 252, 265) par l'intermédiaire de l'un des contacts (155, 156, 157, 158, 255, 256, 257, 270, 271, 272, 273) du réseau (151, 152, 251, 252, 265), et
le test (S2) des autres contacts (155, 156, 157, 158, 255, 256, 257, 270, 271, 272, 273) associés audit au moins un réseau (151, 152, 251, 252, 265) pour déterminer si le signal de test (102, 103, 202, 203, 210) est présent ;
la génération d'un signal de test (102, 103, 202, 203, 210) ayant une fréquence prédéterminée pour chacun des réseaux (151, 152, 251, 252, 265),
dans lequel, lors de l'injection (S1), un contact est établi avec chacun des réseaux (151, 152, 251, 252, 265) et on injecte le signal de test (102, 103, 202, 203, 210) correspondant dans chacun des réseaux (151, 152, 251, 252, 265), et
dans lequel, lors du test (S2), on détermine sur les contacts (155, 156, 157, 158, 255, 256, 257, 270, 271, 272, 273) non utilisés pour l'injection les fréquences qui sont contenues dans les signaux respectivement présents sur les contacts (155, 156, 157, 158, 255, 256, 257, 270, 271, 272, 273) ;
**caractérisé en ce que**, lors du test (S2), on teste si des fréquences qui ne sont pas injectées dans le réseau (151, 152, 251, 252, 265) du contact (155, 156, 157, 158, 255, 256, 257, 270, 271, 272, 273) respectif sont présentes sur les contacts (155, 156, 157, 158, 255, 256, 257, 270, 271, 272, 273) avec lesquels aucun contact n'est établi ; et
dans lequel, lors du test (S2) des contacts (155, 156, 157, 158, 255, 256, 257, 270, 271, 272, 273) sur lesquels sont présentes des fréquences qui ne sont pas injectées dans le réseau (151, 152, 251, 252, 265) du contact (155, 156, 157, 158, 255, 256, 257, 270, 271, 272, 273) respectif, on détermine un facteur de couplage avec les autres réseaux (151, 152, 251, 252, 265) correspondants.

6. Procédé selon la revendication 5, dans lequel, lors du test (S2) des contacts (155, 156, 157, 158, 255, 256, 257, 270, 271, 272, 273) sur lesquels sont présentes des fréquences qui ne sont pas injectées dans le réseau (151, 152, 251, 252, 265) du contact (155, 156, 157, 158, 255, 256, 257, 270, 271, 272, 273) respectif, on détermine un déphasage des fréquences respectives.

7. Procédé selon l'une des revendications 5 et 6 précédentes, dans lequel, lors du test (S2) du faisceau de câbles (150), on stocke une structure de mémoire (213) qui, pour chacun des contacts (155, 156, 157, 158, 255, 256, 257, 270, 271, 272, 273), contient une information concernant le réseau (151, 152, 251, 252, 265) connecté au contact (155, 156, 157, 158, 255, 256, 257, 270, 271, 272, 273) respectif.

8. Procédé selon l'une des revendications 5 à 7 précédentes, comprenant la détection sans contact de signaux sur des lignes (160, 161) du faisceau de câbles (150), dans lequel, lors du test (S2), on évalue si les signaux correspondant aux lignes (160, 161) respectives sont détectés aux positions prévues.

9. Procédé de fabrication d'un faisceau de câbles (150) comprenant une pluralité de réseaux (151, 152, 251, 252, 265) qui sont formés par des éléments de connexion (153, 154, 253, 254, 254, 266) munis de contacts (155, 156, 157, 158, 255, 256, 257, 270, 271, 272, 273) individuels couplés les uns aux autres par des lignes (160, 161), dans lequel le procédé comprend les étapes suivantes :
la connexion (S21) de contacts (155, 156, 157, 158, 255, 256, 257, 270, 271, 272, 273) individuels des éléments de connexion (153, 154, 253, 254, 266) à l'aide de lignes (160, 161) pour former les réseaux (151, 152, 251, 252, 265) du faisceau de câbles (150), et
le test (S22) du faisceau de câbles (150) conformément au procédé de test d'un faisceau de câbles (150) selon l'une des revendications 5 à 8 précédentes.
